# EUROPEAN PATENT APPLICATION

(11) **EP 4 766 099 A1**
(43) Date of publication of application: **24.06.2026**
(21) Application number: 25175770.4
(22) Date of filing: 12.05.2025
(51) Int. Cl.: H10F 30/223, H01L 21/02, H10F 71/00

(54) **METHOD FOR FABRICATING AN ELECTRONIC OR OPTOELECTRONIC DEVICE AND AN ELECTRONIC OR OPTOELECTRONIC DEVICE**

(30) Priority: 19.12.2024 EP 24221849
(71) Applicant: IHP GmbH - Innovations for High Performance Microelectronics / Leibniz-Institut für innovative Mikroelektronik, 15236 Frankfurt (Oder) (DE); Brandenburgische Technische Universität Cottbus-Senftenberg, 03046 Cottbus (DE)
(72) Inventor: Fischer, Inga, 03046 Cottbus (DE); Wenger, Christian, 15236 Frankfurt (Oder) (DE); Augel, Lion, 03046 Cottbus (DE); Skibitzki, Oliver, 15236 Frankfurt (Oder) (DE)
(74) Representative: Eisenführ Speiser

(57) **Abstract**

The present invention relates to a method for fabricating an electronic or optoelectronic device (100). The method comprises the steps of:
- providing a layer stack comprising along a stacking direction a wafer (105) and one or more dielectric mask layers;
- structuring the one or more dielectric mask layers (107) by selectively etching at least one window into the one or more dielectric mask layers; and
- selectively growing a nanostructure (102) of the electronic or optoelectronic device in the at least one window by means of epitaxy.

## Description

### TECHNICAL FIELD

The present invention relates to a method for fabricating an electronic or optoelectronic device. Furthermore, the present invention relates to an electronic or optoelectronic device. The present invention also relates to use of the electronic or optoelectronic device as a PIN-diode for wavelength-selective and polarization-selective detection of light.

### BACKGROUND OF THE INVENTION

In Appl. Phys. Lett. 122, 121701 (2023), "Robust Si/Ge heterostructure metasurfaces as building blocks for wavelength-selective photodetectors", J. Schlipf et al. describe a design for silicon-compatible vertical Germanium PIN photodiodes structured into all-dielectric metasurfaces. It is furthermore described that proof-of-principle metasurfaces have been fabricated on silicon-on-insulator wafers in a top-down process. According to J. Schlipf et al., simulations and measurements of the spectroscopic properties, specifically the absorption, show high spectral selectivity, and absorption efficiencies as large as those in bulk Germanium layers with about four times the Ge layer thicknesses. The metasurface structures can described to be tuneable to the target wavelength through tailoring of the lateral geometry.

Yet, there is an ongoing need for providing further improved electronic or optoelectronic devices, in particular, for wavelength- selective and polarization-selective detection of light, and methods for fabricating these devices.

### SUMMARY OF THE INVENTION

The present invention is based on the objective of providing an improved method for fabricating an electronic or optoelectronic device. Furthermore, the present invention is based on the objective of providing an improved electronic or optoelectronic device, in particular, for wavelength-selective and polarization-selective detection of light.

According to the present invention, a method for fabricating an electronic or optoelectronic device is proposed. The method comprises the steps of:
- providing a layer stack comprising along a stacking direction a wafer, and one or more dielectric mask layers, preferably, comprising an etch stop layer;
- structuring the one or more dielectric mask layers by selectively etching at least one window into at least one of the one or more dielectric mask layers, in particular, up to the etch stop layer; and
- selectively growing a nanostructure of the electronic or optoelectronic device in the at least one window by means of epitaxy.

The present invention includes the recognition that with a top-down structuring, the etch depth in the layer underneath the nanostructures, e.g., a Si layer, has a decisive influence on the spectral position of the peak photocurrent of an electronic or optoelectronic device. Every nanometre difference in the etch depth may yield a shifts of the peak photocurrent. Yet, in a top-down approach, etching can result in inhomogeneities over the entire wafer surface. Thus, a more reliable and accurate way of fabricating an electronic or optoelectronic device is desired.

With the method according to the present invention, shifts of the peak photocurrent can be avoided since no top-down structuring is employed for fabricating the nanostructures. Instead, in the proposed method, a bottom-up approach is used in which a nanostructure of the electronic or optoelectronic device is selectively grown in the at least one etched window by means of epitaxy. This has the advantage that a risk of etching into the layer underneath the nanostructures is avoided, which may improve the performance of the fabricated electronic or optoelectronic device and make the electronic or optoelectronic device function more reliable. It is thus an important distinction of the proposed method to top-down approaches as pursued in the above-mentioned article Appl. Phys. Lett. 122, 121701 (2023), of J. Schlipf *et al.* that in the proposed method, the area between nanostructures is not exposed to or affected by etching of the windows. That is, etching may be employed for fabricating the windows in which the nanostructures are selectively grown by means of epitaxy. This means that the surface roughness of the layer underneath the one or more dielectric layers stays unchanged, which is advantageous for the optical properties of the electronic or optoelectronic device, e.g., exhibiting a narrower peak, and/or a higher peak amplitude in responsivity spectra. Fabricating the nanostructures in a bottom-up process also has the advantage that a wider range of materials can be combined epitaxially to form an electronic or optoelectronic device. For example, with the bottom-up process, it is possible to combine Ge or other group-IV materials with group-III-V compound materials epitaxillay that would not be possible with the same quality in a top-down process. Another advantage of the bottom-up approach is that the nanostructures can be fabricated with good control so that they are comparatively robust against fabrication errors. This contributes to a further improved performance of the electronic or optoelectronic device.

In particular, with the proposed method it is possible to fabricate an electronic or optoelectronic device with several nanostructures that are comparatively small in size and substantially identical in shape. Moreover, the proposed method makes it possible to fabricate the several nanostructures with comparatively high quality, e.g., with very few geometry imperfections, on layers with very defined thickness and very low surface roughness. For example, with the proposed method, it is possible to incorporate metasurfaces in the absorbing layer of a nanostructure configured as a PIN-diode with a large degree of reproducibility for electronic or optoelectronic devices, enabling mass fabrication of such electronic or optoelectronic devices with well-defined optical properties with high yield.

Preferably, the nanostructures have a diameter in at least one lateral direction that is parallel to the wafer surface 50 nm to 2 µm. In particular, for a mask for integrating or selectively growing group-III-V mateials, a targeted diameter of 1 µm to 2 µm such as of 1239 nm to 1944 nm may be favoured, in order to address a wavelength range between 1300 nm and 1900 nm for wavelength-selective photo detection. The nanostructures may be in a regular or an irregular arrangement. The arrangement may be determined by the mask used for the selective etching of the at least one window into the one or more dielectric mask layers. The nanostructures may have various forms and may be in the form of cylinders, squares or may have a Z-shape. With the shape of the nanostructures, it is possible to define the sensitivity to the polarisation of impinging light. With the size of the nanostructures, it is possible to define the sensitivity to a certain wavelength or wavelength range of impinging light. Moreover, with the distance between the nanostructures it is possible to define the lattice constant and thus also the sensitivity to a certain wavelength or wavelength range of impinging light. Thereby, it is possible that the nanostructures are configured to act as the absorbing layer of an electronic or optoelectronic device. The nanostructure may be a dielectric nanostructure, in which only the semiconducting layers are nanostructured. It is also possible that the nanostructure is a hybrid metal-dielectric nanostructure, in which semiconductor and metal layers are nanostructured. The hybrid nanostructure may have the advantage that it can be designed to be more robust against fabrication errors.

Preferably, the nanostructure comprises a group IV material and/or a III-V and/or a II-VI compound material. A group III-V may be InN, GaN, GaAs, InAs, GaSb, GaP, InP and/or InSb, a group IV material may be Si, Ge and/or Ge-rich SiGe. Yet, it is particularly preferred that the nanostructure comprises germanium. In particular, with an arrangement of Ge nanostructures, e.g. two-dimensional arrangement of sub-wavelength-sized PIN diodes embedded in continuous contacting layers, it is possible to obtain wavelength-selective and/or polarization-selective absorption in the Ge. This absorption may be converted to a photocurrent by embedding the Ge nanostructures in doped Ge and/or Si as well as contacting layers. For example, a Schottky diode, e.g. no doping necessary on one side of the diode can be realised. The nanostructures may be embedded in SiO₂ on top of and/or under Si selective layers. It is also possible that the nanostructures are Si-Ge-Si heterostructures.

Preferably, the one or more dielectric mask layers comprise SiO₂ and/or SiN (including, e.g., SiNₓ or Si₃N₄) and/or N-rich Si and/or other oxide materials. It is particularly preferred to have the one or more dielectric mask layers formed as a sandwich structure of SiO₂ and SiN. In particular, SiO₂ and SiN are preferred due to their CMOS compatibility and mature knowledge as hard mask material in Si technology. There may be different steps, e.g., dry and wet etching, involved in opening the windows and the different materials may react differently to these etching steps.

Preferably, at least one of the nanostructures is configured as an optical switch or a PIN photodiode or a PIN photodetector or a light emitting diode or a modulator or a tuneable filter. For example, an electroabsorption modulator may be realized for which generally only a PIN diode is needed (Franz-Keldysh-Effect).

In the method, it is preferred that selectively growing the nanostructure in the at least one window is performed by selective chemical vapour deposition (CVD) growth. In particular, it is possible to grow the nanostructure in the at least one window employing a remote plasma chemical vapour deposition (RPCVD) or metal-organic chemical vapour deposition (MOCVD) technique. It is also possible to grow the nanostructure in the at least one window using molecular-beam epitaxy (MBE).

The method may comprise an optional step of chemical-mechanical polishing that is carried out after the selective growth of the nanostructure. With the chemical-mechanical polishing process of the outer top surface of the electronic or optoelectronic device, a surface roughness in the range of 0.5 nm or less can be realised. In particular, in the method, the nanostructure may be grown by selective CVD growth in pre-structured oxide windows, followed by chemical-mechanical polishing. With the chemical-mechanical polishing it is possible to planarize the surface of the nanostructure such that they are substantially identical in height.

Preferably, the etch stop layer of the one or more dielectric mask layers comprises SiN. It is also possible to use thermal or high temperature oxides, e.g., SiO₂, and/or SiN layers as etch stop layer, e.g., on top of a Si layer. In this way, it is possible to stop the etching, e.g., in SiO₂ or SiN, preventing the damage of the underlying Si surface. The remaining etch stop layer may be removed before epitaxial growth of nanostructure, e.g., by selective wet etching, e.g., using hydrofluoric acid (HF) and phosphoric acid (H₃PO₄)solutions, respectively.

In the method, it is preferred that the structuring of the one or more dielectric mask layers is performed using a photolithography mask and a dry etching technique. It is also possible that e-beam lithography is employed. By means of the structuring of the one or more dielectric mask layers, pitch and diameter can be defined and tunable via the photolithography mask.

Preferably, the wafer is a silicon-on-insulator (SOI) wafer or a Si wafer. A SOI or a Si wafer is preferred since in this case, the method is compatible with Si technology and in particular with complementary metal-oxide-semiconductor (CMOS) techniques.

The method may comprise fabricating a bottom contact layer for electrically contacting the nanostructure. Preferably, the bottom contact layer comprises Si. The method may comprise fabricating a top contact layer for electrically contacting the nanostructure. In particular, in the method, the nanostructure may be contacted with a top contacting layer, e.g., may be a transparent conductive ZnO layer, and with a bottom contacting layer, e.g., comprising Si. Generally, a top contacting layer may comprise a conducting 2D material such as graphene or a transparent oxide such as indium tin oxide (ITO), aluminium doped zinc oxide (AZO), ZnO, or doped Si. Doped Si is preferred since it is quasi transparent above 1100 nm. The bottom contact layer can be realised by making a back contact by using a through-silicon via (TSV) process. This may include etching deep holes in the backside of the wafer until reaching the contact area of the device structure and then filling it up by contact material (metallization). Alternatively, in case the Si layer has sufficient thickness it is also possible to contact the bottom contacting layer from the top. For example, the bottom contacting layer may be formed by the top Si layer of a SOI wafer. This may lead to comparatively higher series resistances of the electronic or optoelectronic device.

It is a particular advantage of the method that after selectively etching of the at least one window into the one or more dielectric mask layers, a surface roughness at the interface of the at least one window and the semiconductor substrate is 0.5 nm or less.

In particular, with the method, by selectively growing the nanostructure in the at least one window, a surface roughness at the interface of the semiconductor substrate and the nanostructure of 2 nm or less, e.g., 1 nm or less, can be fabricated. In particular, by combining dry and wet etching processes with the use of one or more etch stop layer, it is possible to achieve similar surface roughness in the nanostructure as in the initial wafer substrate roughness of less than 0.5 nm. The Si surface reopened for epitaxial growth, e.g., after pre-epi clean and preferably a removal of 5 to 10 nm thermal oxide layer, is to be expected comparatively clean in terms of contamination of foreign-element atoms and their interstitials diffused into Si surface, with respect to the regions outside the holes such as the mask stack region. It is possible that there is a slight increase in interface roughness after growth, however, still, it is possible to achieve a roughness of 2 nm or less that is homogeneous over substantially the whole wafer.

According to the present invention, an electronic or optoelectronic device is proposed. The device comprises a wafer and one or more dielectric mask layers comprising an etch stop layer. The one or more dielectric mask layers comprise at least one window that is etched into at least one of the dielectric mask layers. Furthermore, the device comprises a nanostructure arranged in the at least one window. It is a characteristic feature that a surface roughness at an interface of the at least one etched window and the semiconductor substrate is in average 0.5 nm or less. For example, a surface roughness may be in the range of rms (root-mean-squared) less than 0.5 nm, e.g., after thermal oxidation of Si and wet etching as well as after CMP processing. It may be beneficial to clean a Si surface, e.g., in the at least one etched window, preferably, prior to epitaxial growth, e.g., by oxidising the surface and removing it afterwards by HF. This may result in low rms values and after annealing even typical Si step structure of about 1 nm to 2 nm.

The electronic or optoelectronic device may be fabricated using the method for fabricating an electronic or optoelectronic device as described herein. In particular, the device may have several sub-wavelength-sized nanostructures in a two-dimensional arrangement. The nanostructures may be in a regular or an irregular arrangement and may various forms such as cylinders, squares or Z-shaped structures.

Preferably, a surface roughness at the interface of the semiconductor substrate and the nanostructure arranged in the window is 2 nm or less such as 0.5 nm or less. Thereby, it is possible to achieve good homogeneity in the height of the nanostructures of the electronic or optoelectronic device.

The device may comprise a continuous top contacting layer and a continuous bottom contacting layer that are arranged and configured for electrically contacting the nanostructure. In particular, the device's nanostructure may be configured as a PIN-photodiode for wavelength- and polarization-selective detection of light. For example, the PIN-diode can be implemented by embedding a Ge metasurface in doped Si as well as top and bottom contacting layers. In the device it is also possible that the nanostructure is configured as an optical switch.

The present invention also relates to a use of the electronic or optoelectronic device as described herein as a PIN-diode for wavelength-selective and polarization-selective detection of light, comprising obtaining wavelength-selective and/or polarization-selective absorption in the PIN-diode and converting the detected light into to a photocurrent.

It shall be understood that the method for fabricating an electronic or optoelectronic device of claim 1, the electronic or optoelectronic device of claim 11 and the use of the device of claim 15 have similar and/or identical preferred embodiments, in particular, as defined in the dependent claims.

It shall be understood that a preferred embodiment of the present invention can also be any combination of the dependent claims or above embodiments with the respective independent claim.

These and other aspects of the invention will be apparent from and elucidated with reference to the embodiments described hereinafter.

### BRIEF DESCRIPTION OF THE DRAWINGS

In the following drawings:
- Fig. 1:: schematically and exemplary shows an intermediate product of a method for fabricating an electronic or optoelectronic device;
- Fig. 2:: schematically and exemplary shows an intermediate product of a method for fabricating an electronic or optoelectronic device;
- Fig. 3:: schematically and exemplary shows an intermediate product of a method for fabricating an electronic or optoelectronic device that may result from lithography, dry etching, wet etching and liner oxidation processing the intermediate product described with reference to figure 2;
- Fig. 4:: schematically and exemplary shows an intermediate product of a method for fabricating an electronic or optoelectronic device that may result from selective Ge deposition in the windows of the intermediate product described with reference to figure 3, but before capping and/or top contacting;
- Fig. 5:: schematically and exemplary shows an intermediate product of a method for fabricating an electronic or optoelectronic device that depicts what would happen if the Ge selective growth as discussed for the intermediate product described with reference to figure 4 would be stopped on the same level as the oxide layer surface;
- Fig. 6:: schematically and exemplary shows an intermediate product of a method for fabricating an electronic or optoelectronic device that depicts what would hap- pen if the Ge selective growth as discussed for the intermediate product described with reference to figure 4 would be stopped above the level of the oxide layer surface;
- Fig. 7:: schematically and exemplary shows an intermediate product that may be obtained by further processing the intermediate product discussed with reference to Fig. 6; and
- Fig. 8:: schematically and exemplary shows in a) to d) four different intermediate products of different optoelectronic devices;

### DETAILED DESCRIPTION OF EMBODIMENTS

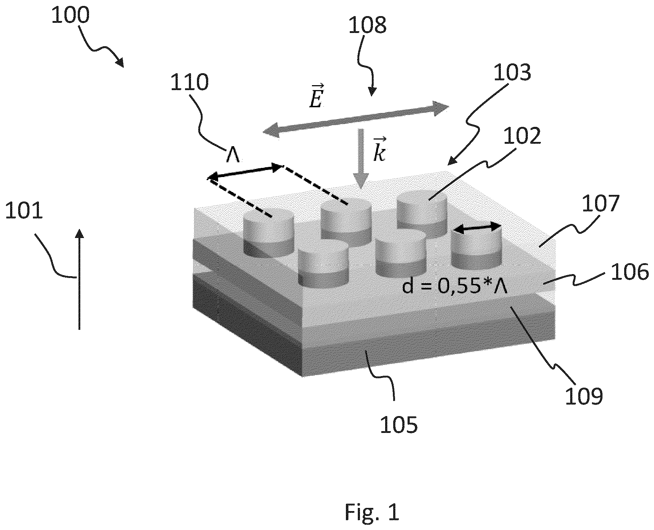

Figure 1 schematically and exemplary shows an intermediate product of a method for fabricating an electronic or optoelectronic device100 comprising along a stacking direction 101 a SOI wafer comprising a Si substrate 105, an oxide layer 109 and a bottom contacting layer 106, and a dielectric mask layer 107 comprising SiO₂ and/or SiN, and in particular SiN. The dielectric mask layer 107 may contain an etch stop. The device 100 comprises a plurality of nanostructures 102 configured as PIN diodes and comprising Ge. The nanostructures 102 are arranged in windows 103 that have been etched into the dielectric mask layer 107. Moreover, the nanostructures 102 are arranged in a two-dimensional arrangement of sub-wavelength-sized nanostructures. The nanostructures 102 are embedded between a continuous top contacting layer (not shown) and the continuous bottom contacting layer 106. Alternatively, the nanostructures 102 may be configured, e.g., as metallic-dielectric Ge-based nanostructures.

The nanostructure arrangement is chosen so as to obtain wavelength-selective and/or polarization-selective absorption of light 108 in the Ge. This absorption can be converted to a photocurrent by embedding the Ge nanostructures in doped Si as well as contacting layers. In the device 100, the nanostructures 102 have a cylindrical shape with a predefined diameter d=0.55*lattice constant. Yet, other shapes are possible such as squares or Z-shaped structures. Furthermore, in device 100, the nanostructures 102 are arranged in a regular arrangement with a constant pitch distance 110. Yet, it is also possible that the nanostructures 102 are arranged in an irregular arrangement.

The device 100 has been fabricated using a bottom-up approach in which the nanostructures 102 have been epitaxially grown with a bottom-up growth in the windows 103. Thereby, it is possible to ensure that etching into the Si between the Ge nanostructures 102 is avoided which otherwise may change the optical properties of the device 100.

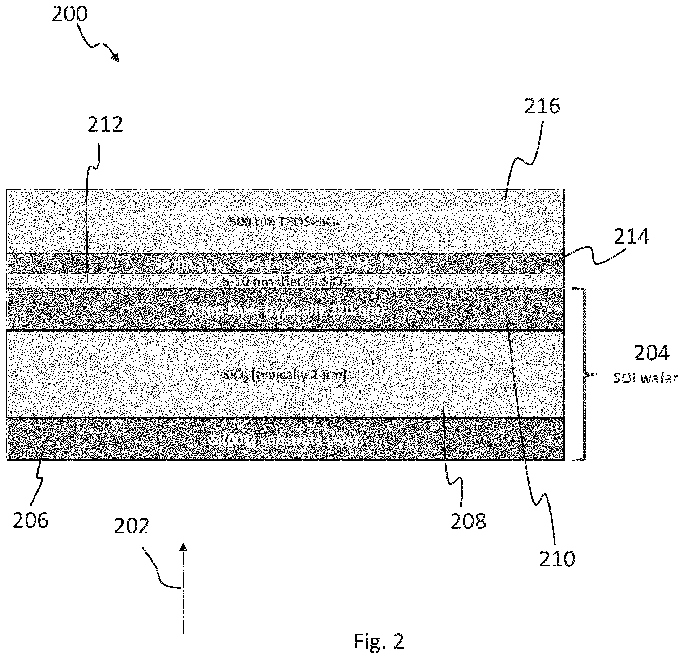

Figure 2 shows an intermediate product 200 of a method for fabricating an electronic or optoelectronic device, e.g., as discussed with reference to figure 1. The intermediate product 200 has not been subject to lithography and dry etching.

The intermediate product 200 comprises along a stacking direction 202 a SOI wafer 204 comprising a Si(001) substrate layer 206, a SiO₂ layer 208 with a thickness of approximately 2 µm and a Si top layer 210 implementing the bottom contacting layer with a thickness of approximately 220 nm. On the SOI wafer 204, there is arranged an approximately 10 nm thick layer of thermal SiO₂ 212. On top of the thermal SiO₂ layer 212, there is arranged a dielectric mask layer of 50 nm thick SiN that is used as etch stop layer 214. The etch stop layer 214 is follows by 500 nm of tetraethoxysilane (TEOS)-SiO₂ 216. TEOS is used as one possible example and it is also possible to use other oxide types like e.g. HDP-oxide.

The thermal SiO₂ 212 is a protection layer of the underlying Si surface. After dry etching to the SiN etch stop layer 214, the remaining SiN may be removed by H₃PO₄ wet etching, so that in the hole only the thermal oxide layer will remain.

Moreover, the thermal SiO₂ 212 is a layer that protects the Si surface before the epitaxy process will be performed. Before the epi process is conducted, this thermal oxide layer 212 may be removed by a standard pre-epi wet clean (HF-based) process, so that the selective epitaxy may have a virgin and smooth oxide/particle free surface to perform epitaxial growth.

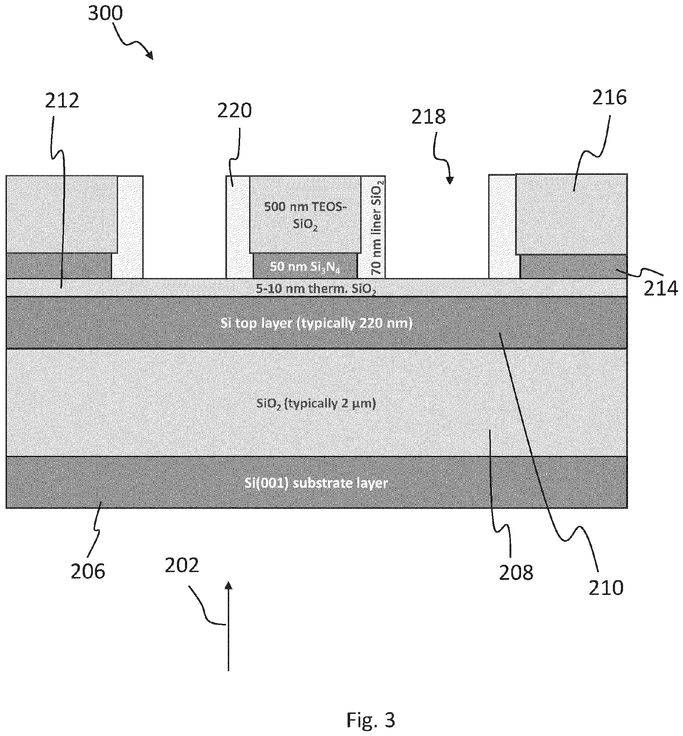

Figure 3 shows an intermediate product 300 of a method for fabricating an electronic or optoelectronic device that may result from lithography and dry etching the intermediate product 200 described with reference to figure 2. The lithography and dry etching results in windows 218 that extend from the top surface of the TEOS-SiO₂ 216 into the layer stack and through the TEOS-SiO₂ 216 and the etch stop layer 214. At the side walls of the windows 218 there is an approximately 70 nm thick liner 220 comprising SiO₂. The liner oxide 220 is applied to mask the opened SiN layer by dry etching at both sides of the window 218. To perform selective epitaxy, it is beneficial to have SiO₂ to Si as sites. This is because Ge is highly selective to SiO₂ but not to SiN. The attendance of SiN sites will affect the selective epi process very negatively.

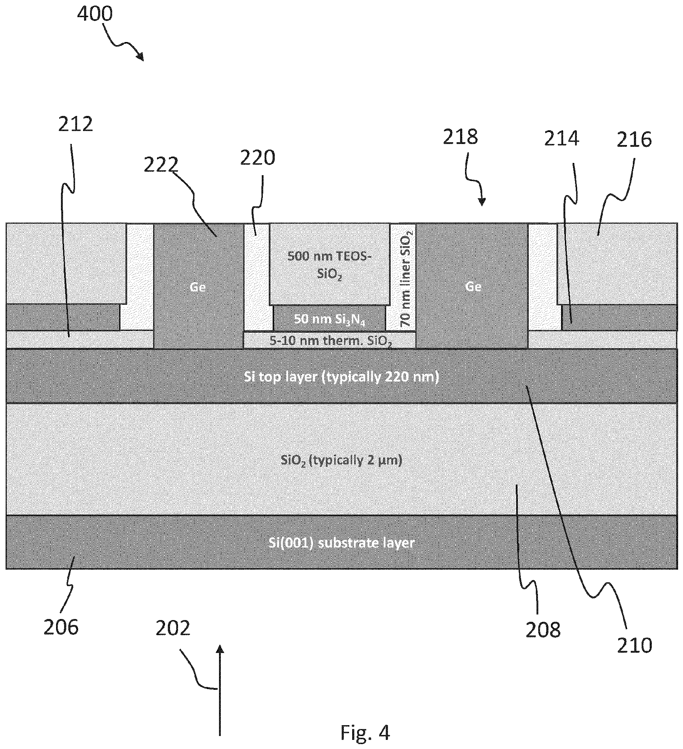

Figure 4 shows an intermediate product 400 of a method for fabricating an electronic or optoelectronic device that may result from selective Ge deposition in the windows 218 of the intermediate product 300 described with reference to figure 3, but before capping and/or top contacting. Accordingly, Ge nanostructures 222 have been fabricated in the windows 218 by means of epitaxy employing selective Ge deposition techniques.

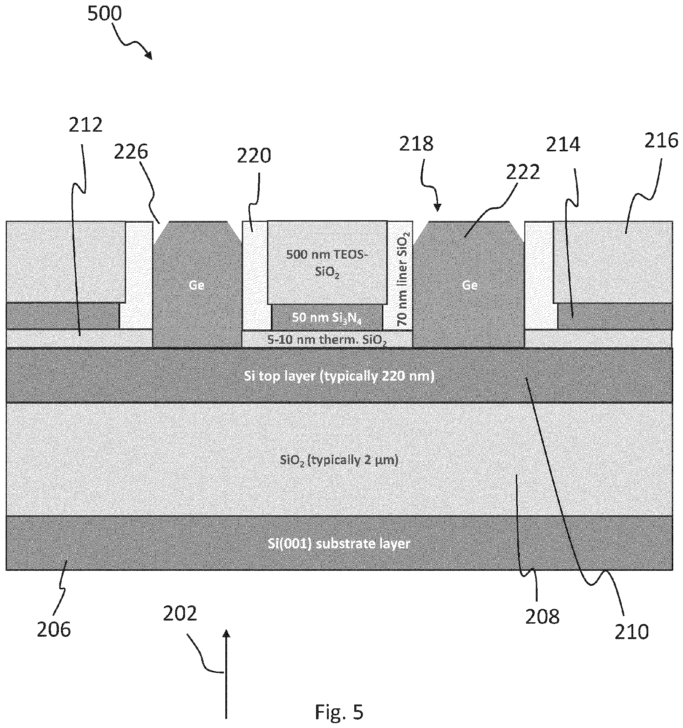

Figures 5 to 7 show different intermediate products that may result from further processing the intermediate product 400 described with reference to figure 4. In particular, figures 5 to 7 discuss properties of a mask material and the impact on the further processing of the intermediate products. That is, it is preferred if a mask material thickness is sufficiently thick, so that after a CMP step, the desired, e.g., minimal or optimal, mask thickness is reached. Further, it is preferred if the epitaxial process is also facet controlled in a way that the overgrown material is filling completely the growth window 218. Otherwise, even with using CMP, it is possible to end up with voids 226.

Figure 5 shows an intermediate product 500 of a method for fabricating an electronic or optoelectronic device that shows what would happen if the Ge selective growth as discussed for the intermediate product 400 described with reference to figure 4 would be stopped on the same level as the oxide layer surface of TEOS-SiO₂ 216. That is, due to facet growth, the Ge surface may display voids 226 on the edge of windows 218.

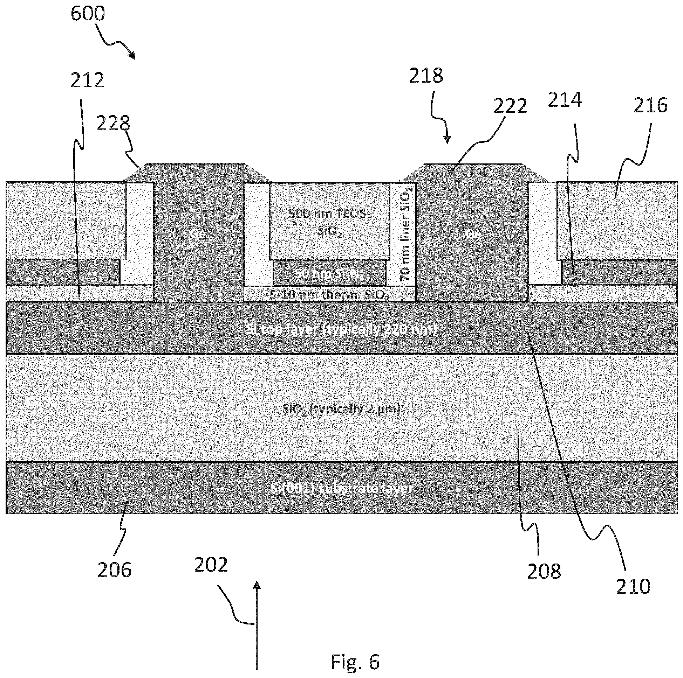

Figure 6 shows a preferred way of fabricating the nanostructures 222 that can counteract the undesired effect of void formation discussed with reference to figure 5. In particular, figure 6 shows an intermediate product 600 that can be obtained by further processing the intermediate product 400 discussed with reference to figure 4. Intermediate product 600 is obtained after selective Ge epitaxy but before a CMP process is conducted. For obtaining intermediate product 600, Ge is overgrowing the TEOS-SiO₂ 216 displaying a faceted surface 228.

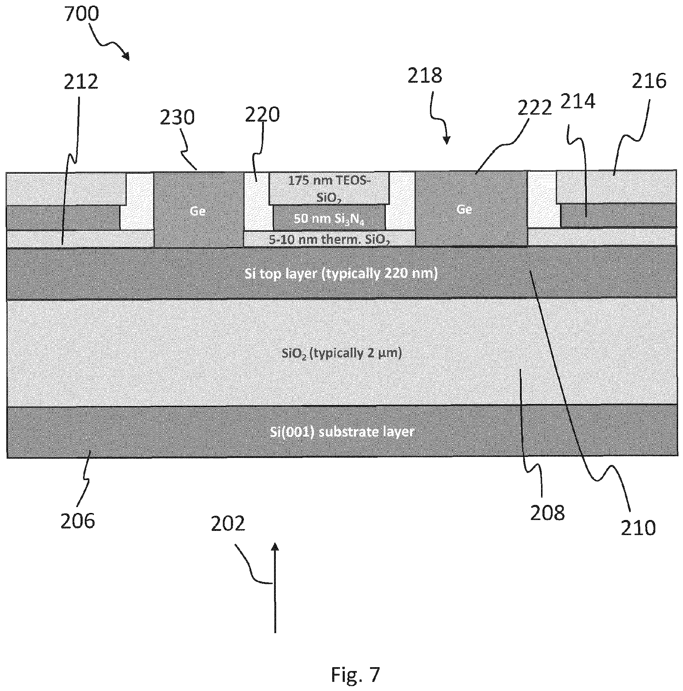

Figure 7 shows an intermediate product 700 that may be obtained by CMP polishing the intermediate product 600 discussed with reference to figure 6. In particular, for obtaining intermediate product 700, intermediate product 600 may CMP polished down to approximately 175 nm thickness of the TEOS-SiO₂ layer 216. The selectively grown Ge surface 230 is now on the same level as the top surface of the TEOS-SiO₂ layer 216. On top of the polished surface, a top contacting layer (not shown) may be fabricated.

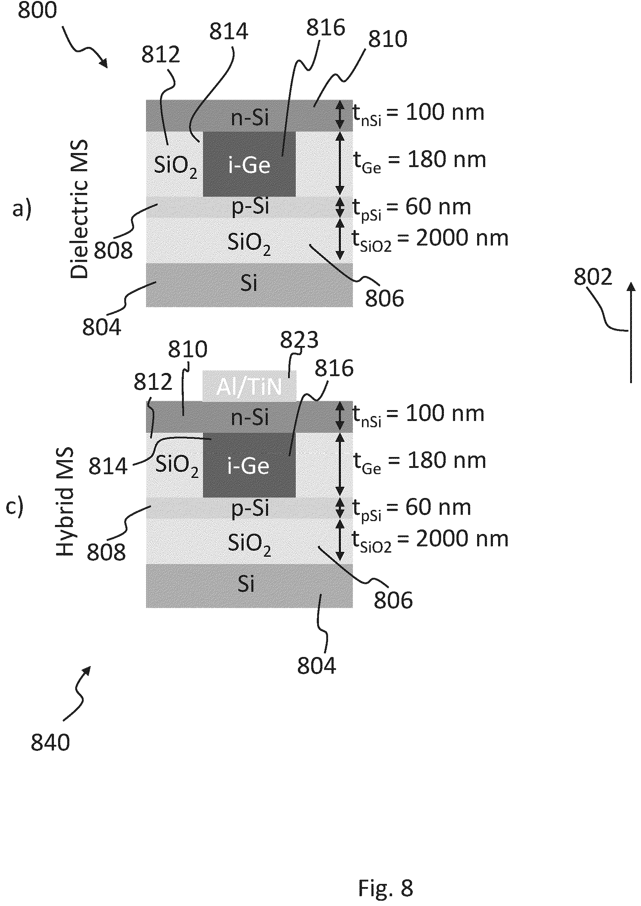

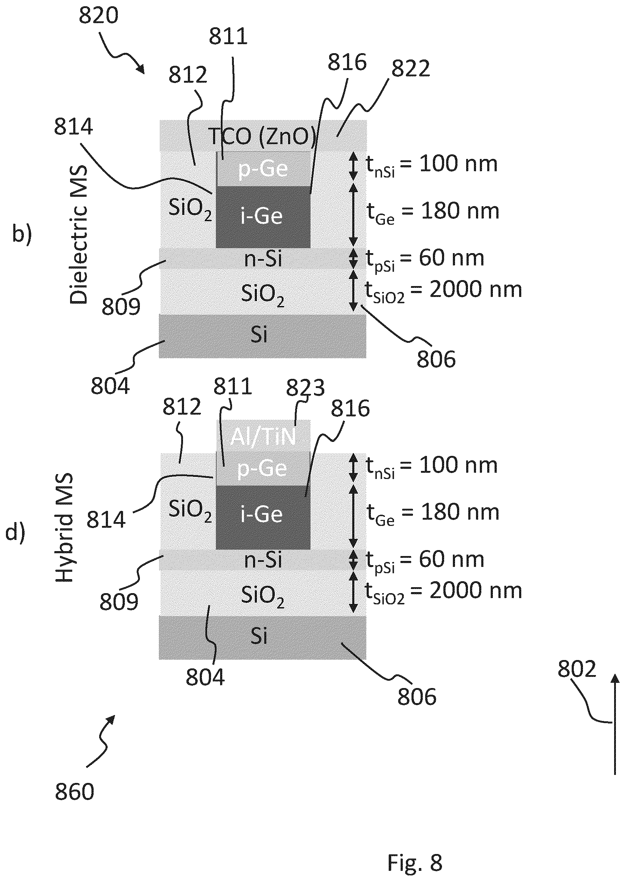

Figure 8 schematically and exemplary shows in a) to d) four electronic or optoelectronic devices 800, 820, 840, 860.

In figure 8a), the electronic or optoelectronic devices 800 comprises along a stacking direction 802, an SOI wafer comprising a Si substrate 804, followed by a SiO₂ layer 806. The electronic or optoelectronic devices 800 further comprises a bottom contacting layer comprising p-Si 808 and a n-Si top contacting layer 810 and embedded between the bottom and top contacting layers 808, 810 a dielectric mask layer 812 of SiO₂. The dielectric mask layer 812 comprises a window 814 that is etched into the dielectric mask layer 812. In the window 814, a i-Ge nanostructure 816 is arranged that has been epitaxially grown within the window 814 using selective chemical vapour deposition. The i-Ge nanostructure 816 of electronic or optoelectronic device 800 is a dielectric i-Ge nanostructure 816 and forms a PIN diode together with the bottom and top contacting layers 808, 810.

The electronic or optoelectronic device 820 shown in figure 8b) differs from the electronic or optoelectronic devices 800 described with reference to figure 8a) in that the top contacting layer 810 comprising n-doped Si of electronic or optoelectronic devices 800 is replaced by a top contacting layer 822 comprising a transparent conductive oxide such as ZnO. Furthermore, the i-Ge nanostructure 816 of electronic or optoelectronic device 820 is a dielectric i-Ge nanostructure 816 and forms a PIN diode together with a n-Si bottom contacting layer 809 and p-Ge top contacting layer 811. The p-Ge top contacting layer 811 is also positioned with in the window 814. The ZnO top contacting layer 822 is arranged on top of the p-Ge top contacting layer 811 of the PIN diode and the SiO₂ dielectric mask layer 812.

The electronic or optoelectronic devices 840 shown in figure 8c) differs from the electronic or optoelectronic devices 800 described with reference to figure 8a) in that it comprises an additional Al/TiN top contact 823 that is arranged on the n-Si top contacting layer 810. The i-Ge nanostructure 816 of electronic or optoelectronic device 840 is a hybrid i-Ge nanostructure 816.

The electronic or optoelectronic devices 860 shown in figure 8d) is similar to the electronic or optoelectronic devices 820 described with reference to figure 8b). A difference between these electronic or optoelectronic devices 820, 860 is that the Al/TiN top contact 823 of the electronic or optoelectronic device 860 has a comparatively smaller lateral extension and is made from Al/TiN instead of ZnO. In particular, the lateral extension of the top contact 823 corresponds to the lateral extension of the i-Ge nanostructure 816. Furthermore, in the electronic or optoelectronic device 860, a graphene layer should to be deposited on top to ensure contacting. The i-Ge nanostructure 816 of electronic or optoelectronic device 860 is also a hybrid i-Ge nanostructure 816. Furthermore, the electronic or optoelectronic devices 860 shown in figure 8d) has a dielectric i-Ge nanostructure 816 and forms a PIN diode together with a n-Si bottom contacting layer 809 and p-Ge top contacting layer 811. The dielectric i-Ge nanostructure 816 and p-Ge top contacting layer 811 are both arranged with in the window 814.

In each of the electronic or optoelectronic devices 800, 820, 840, 860, the structuring of the i-Ge nanostructure 816 may be done by selective CVD growth in pre-structured oxide windows 814, followed by chemical-mechanical polishing. This is one of the crucial differences to known devices that are based on a top-down approach.

Both, dielectric i-Ge nanostructure 816, in which only the semiconducting layers are nanostructured, and hybrid metal-dielectric i-Ge nanostructure 816, in which semiconductor and metal layers are nanostructured are possible with the present invention. The hybrid i-Ge nanostructure 816 can be designed to be more robust against fabrication errors.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

The mere fact that certain measures are recited in mutually different dependent claims does not indicate that a combination of these measures cannot be used to advantage.

Any reference signs in the claims should not be construed as limiting the scope.

## Claims

1. A method for fabricating an electronic or optoelectronic device, the method comprising the steps of:
- providing a layer stack comprising along a stacking direction a wafer and one or more dielectric mask layers;
- structuring the one or more dielectric mask layers by selectively etching at least one window into at least one of the one or more dielectric mask layers; and
- selectively growing a nanostructure of the electronic or optoelectronic device in the at least one window by means of epitaxy.

2. The method according to claim 1, wherein the one or more dielectric mask layers comprise SiO₂ and/or SiN.

3. The method according to at least one of the preceding claims, wherein the nanostructure is configured as an optical switch or a PIN photodiode or a PIN photodetector or a light emitting diode or a modulator or a tuneable filter.

4. The method according to at least one of the preceding claims, wherein the nanostructure comprises a group IV material, preferably germanium, and/or a III-V and/or a II-VI compound material.

5. The method according to at least one of the preceding claims, wherein the nanostructure is a hybrid metal-dielectric nanostructure, in which semiconductor and metal layers are nanostructured.

6. The method according to at least one of the preceding claims, wherein selectively growing the nanostructure in the at least one window is performed by selective chemical vapour deposition growth.

7. The method according to at least one of the preceding claims, comprising a step of chemical-mechanical polishing that is carried out after the selective growth of the nanostructure.

8. The method according to at least one of the preceding claims, wherein the etch stop layer comprises SiN.

9. The method according to at least one of the preceding claims, wherein structuring of the one or more dielectric mask layers is performed using a photolithography mask and a dry etching technique.

10. The method according to at least one of the preceding claims, wherein after selectively etching of the at least one window into the one or more dielectric mask layers, a surface roughness at the interface of the at least one window and the one or more dielectric mask layers is 2 nm or less.

11. An electronic or optoelectronic device, comprising
- a wafer and one or more dielectric mask layers comprising an etch stop layer, the one or more dielectric mask layers comprising at least one window etched into at least one of the dielectric mask layers, and
- a nanostructure arranged in the at least one window, wherein
a surface roughness at an interface between the etch stop layer and the dielectric mask layer is in average 0.5 nm or less.

12. The device according to claim 11, wherein a surface roughness at the interface of the etch stop layer and the nanostructure arranged in the window is 2 nm or less.

13. The device according to claim 11 or 12, comprising a continuous top contacting layer and a continuous bottom contacting layer that are arranged and configured for electrically contacting the nanostructure.

14. The device according to at least one of claims 11 to 13, wherein the nanostructure is configured as a PIN-photodiode for wavelength- and polarization-selective detection of light or as a light emitting diode.

15. A use of the device according to at least one of claims 11 to 14 as a PIN-diode for wavelength-selective and polarization-selective detection of light, comprising obtaining wavelength-selective and/or polarization-selective absorption in the PIN-diode and converting the detected light into to a photocurrent.
